Europäisches Patentamt

European Patent Office

Office européen des brevets

(11) Publication number: **0 064 126**
**A2**

(12) # EUROPEAN PATENT APPLICATION

(21) Application number: **82100341.5**

(22) Date of filing: **19.01.82**

(51) Int. Cl.³: **H 03 F 3/45**

(30) Priority: **27.04.81 US 258197**

(43) Date of publication of application:
**10.11.82 Bulletin 82/45**

(84) Designated Contracting States:
**DE FR GB**

(71) Applicant: **International Business Machines Corporation**

**Armonk, N.Y. 10504(US)**

(72) Inventor: **Castro, Fernando**
**224 S. Panorama Circle**
**Tucson Arizona 85705(US)**

(72) Inventor: **Fountain, Franklin Camille**
**3062 N. Sourdough Place**
**Tucson Arizona 85715(US)**

(72) Inventor: **Lewkowicz, Julian**
**8032 E Presidio**
**Tucson Arizona 85715(US)**

(74) Representative: **Chaudhry, Mohammad Saeed**
**IBM United Kingdom Patent Operations Hursley Park**
**Winchester Hants, S021 2JN(GB)**

(54) A differential amplifier.

(57) This invention relates to a differential amplifier which is compensated for temperature and power supply variations. The amplifier includes a differential pair of transistors (11, 12) with resistors (22, 23) in the collector circuits and a current source transistor (25) in the emitter circuits. The base bias signal for the current source transistor (25) is supplied from a correction circuit (36, 48, 54) which includes at least one transistor (54) located proximate the differential transistor. The correction circuit provides a temperature compensated and power supply variation compensated signal to correct the amplifier for these variations.

EP 0 064 126 A2

# A DIFFERENTIAL AMPLIFIER

The present invention relates to a differential amplifier which is compensated for temperature and power supply variations. The invention provides a circuit for use as a preamplifier in the amplifier section of a read section of a magnetic recording device, such as a tape drive. The current source to the preamplifier section is intended to be controlled to make the gain of the preamplifier section independent of resistor values, temperature and power supply variations.

Utilization of differential amplifiers in the prior art is well known. In particular, recording channel technology requires high-gain amplification, which is susceptible of differential amplifier utilization. In such circuits it is desirable to eliminate the effects of power supply variations and temperature variations.

Heretofore in the prior art, such results have been sought by use of various feedback circuits and through utilization of differential amplifiers with active load circuits.

U.S. Patents 4,101,842, 4,090,124 and 4,007,427 disclose high-gain amplifiers with active load and rather high-noise characteristics.

According to the invention there is provided a differential amplifier comprising a pair of transistors connected in differential arrangement with resistors in the collector circuits and a current source transistor connected in the emitter circuit between a high voltage supply and a reference node, characterised in that the amplifier further includes correction circuit means interconnected between the high voltage supply and the base of the current source transistor, said correction circuit means including an amplifier transistor arranged proximate to the differential pair of transistors, for providing a correction bias signal to the base of said current source transistor whereby a high-gain output is obtained from the differential pair of transistors that is compensated for temperature variations and power supply variations.

This invention provides a high-gain low-noise differential amplifier, using resistive load, which can be compensated for temperature and power supply variations without using negative feedback circuitry.

The correction circuit includes a branch having a transistor connected between the V plus and ground circuitry of the differential pair and a second transistor, similarly connected, but having a resistor of predetermined size in its emitter circuit, thus establishing a proportional current flow between the transistors. The second transistor in the correction circuit is proximate to the differential pair and, thus, is subject to the same temperature variations as the differential pair. The current flow through the second transistor is mirrored into a third transistor which has a large resistor in its emitter circuit, and the collector-to-base voltage of the third transistor branch is used as a base signal to the current source transistor to provide a corrected bias signal thereto.

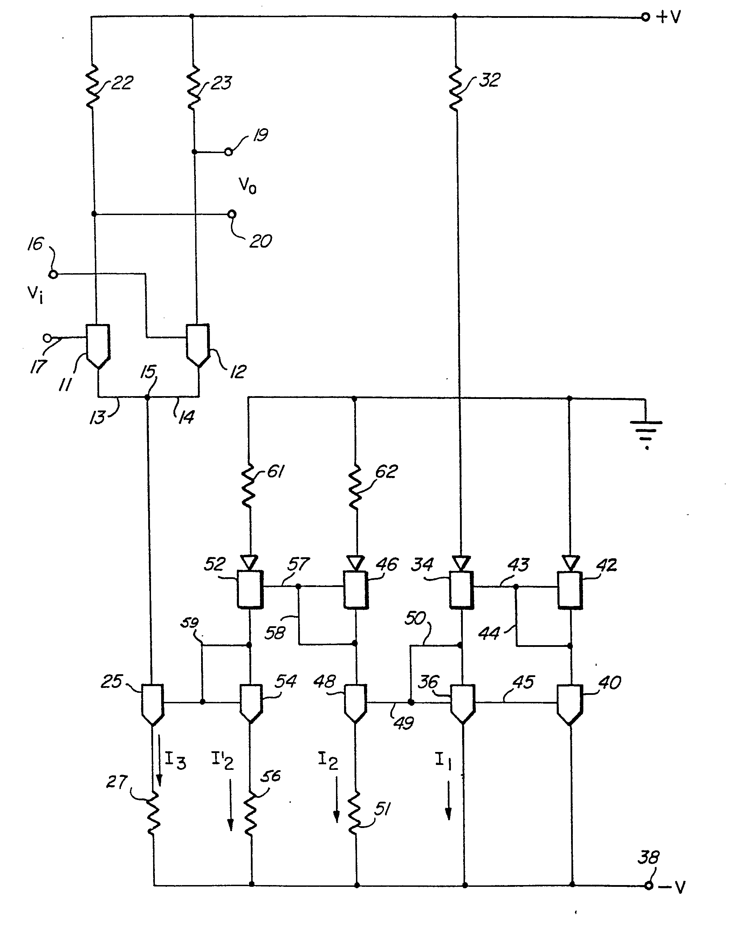

The invention will now be described by way of example with reference to the accompanying drawing, which illustrates a differential amplifier embodying the invention.

Referring now to the drawing, a detailed description of the invention is illustrated including a differential transistor pair 11, 12 having emitters joined by conductors 13, 14 at a node 15. The differential input V1 to the amplifier is provided via nodes 16, 17 interconnected to the respective bases of the transistors; and the differential output $V_o$ from the amplifier is provided from nodes 19, 20 interconnected to the respective collectors of the transistors, as illustrated. Resistors 22, 23 are provided in the collector circuits of transistors 11, 12 and the resistors are connected in common to a V plus source, again as illustrated. The emitter node 15 of the differential pair is connected to the collector of a current source transistor 25 having its emitter connected through a resistor 27 to a reference voltage terminal 38. The circuit described thus far comprises the usual differential pair configuration utilized in a high-gain amplifier.

A correction circuit is also illustrated deriving a signal through a current branch including a resistor 32, a transistor 34, and a transistor 36, interconnected in series between the V plus node and reference voltage node 38. Another circuit branch exists comprising transistors 40, 42 interconnected between the reference voltage node and ground, as illustrated. The base of transistor 34 is interconnected to the base of transistor 42 via a conductor 43 and the base of transistor 42 is interconnected to the collector of transistor 42 via a conductor 44. The base of transistor 36 is interconnected to the base of transistor 40 via a conductor 45.

Yet another circuit branch is comprised of transistor 46, transistor 48, and resistor 51, interconnected between ground and node 38. As illustrated, the base of transistor 36 is connected to the base of transistor 48 by a conductor 49, and the collector of transistor 36 is connected to the common base of transistors 36, 48 by a conductor 50.

Still another circuit branch is comprised of transistor 52, transistor 54, and resistor 56, interconnected between ground and node 38. Again, as shown, the base of transistor 46 is connected to the base of transistor 52 and to the collector of transistor 46 via conductors 57, 58 respectively. The base of transistor 54 is connected to the base of transistor 25 and the collector of transistor 54 is connected to the base of transistor 54 by a conductor 59. Resistors 61, 62 are provided in the emitter circuits of transistors 52, 46, respectively.

It should be noted that resistor 56 is very much larger than resistor 51, and that both resistors 51 and 56 are very much larger than resistor 27. It should also be noted that transistors 36, 48, 54 are located on an integrated circuit chip comprising the amplifier in a position proximate to transistors 11, 12. Accordingly, transistors

4

36, 48, 54 are subject to the same or similar tempera temperature variations as are transistors 11, 12.

With the input preamplifier stage illustrated, typical noise and input impedance requirements necessitate a current source of from one to ten milliamperes. The gain of the differential stage is given by:

$$\frac{V_o}{V_i} = \frac{R_c}{r_e}$$

Where:

$$r_e = \frac{V_T}{I_E} \quad , \quad R_c = R_{22} = R_{23}$$

So:

$$gain = \frac{R_c I_E}{V_T}$$

The gain is a function of resistor $R_c$, current $I_E$, and $V_T$, a temperature dependent variable. To eliminate these dependencies, current source I has to have the following form:

$$I = \frac{V_T K}{R}$$

where K is a constant.

Constant current sources of this form are generally designed around an equation which gives the $V_{BE}$ between two diodes carrying different currents:

$$V_{BE} = V_T \ln \frac{I_1}{I_2}$$

5

This relationship is met by the illustrated circuit.

Thus, PNP transistors 42 and 34 together provide a large current $I_1$ through transistor 36. Resistor 51 is used to set a small current, equal in value to:

$$I_2 = \frac{V_{BE}\ 36\text{-}48}{R_{51}} = \frac{V_T}{R_{51}} \ln \frac{I_1}{I_2}$$

through transistor 48. This current, $I_2$, can be made very small with the proper value of resistor 51. Thus, the ratio of $\dfrac{I_1}{I_2}$ can be very large.

This same current, $I_2$, is mirrored via PNP transistors 46 and 52 through transistor 54. It is labelled $I_2'$ in the Figure. The current through transistor 25, $I_3$, is related to $I_2$ by the equation:

$$I_3 = \frac{I_2 R_{56}}{R_{27}}$$

The selection of values of $R_{56}$ and $R_{27}$ allows $I_3$ to be a large current. The voltage across $R_{56}$ is made large to minimize the $V_{BE}$ 54-25 variations.

The gain of this amplifier circuit then becomes:

$$\frac{Vo}{Vi} = \frac{Rc}{re} = \frac{R_c\ I_3}{2V_T}$$

Substituting for $I_3$ gives:

$$\frac{Vo}{Vi} = \frac{R_c}{2V_T} \times \frac{R_{56}}{R_{27}} \times I_2$$

Substituting for $I_2$ gives the final gain equation:

$$\frac{Vo}{Vi} = \frac{Rc}{2V_T} \cdot \frac{R_{56}}{R_{27}} \cdot \frac{V_T}{R_{50}} \ln \frac{I_1}{I_2}$$

With this circuit a ratio of 100-200 to 1 for $I_1$ to $I_2$ is possible, which makes $\ln \frac{I_1}{I_2}$ essentially a constant for small variations in $\frac{I_1}{I_2}$.

Consequently, the gain is independent of resistor values, temperature or power supply variations.

CLAIMS

1. A differential amplifier comprising a pair of transistors (11, 12) connected in differential arrangement with resistors (22, 23) in the collector circuits and a current source transistor (25) connected in the emitter circuit (13, 14, 15) between a high voltage supply and a reference node (38), characterised in that the amplifier further includes correction circuit means (36, 48, 54) interconnected between the high voltage supply and the base of the current source transistor (25), said correction circuit means including an amplifier transistor (54) arranged proximate to the differential pair of transistors, for providing a correction bias signal to the base of said current source transistor (25) whereby a high-gain output is obtained from the differential pair of transistors that is compensated for temperature variations and power supply variations.

2. An amplifier as claimed in Claim 1, wherein said correction circuit includes a first circuit branch having a transistor connected between the high voltage supply and a reference circuit and a second branch including a second transistor, similarly connected, but having a resistor of predetermined size in its emitter circuit whereby a proportional current flow is established between the transistors, the transistor in the second branch being proximate to the differential transistor pair, and circuit means for mirroring the current flow through the second branch transistor into a third branch including a third transistor having a large resistor in its emitter circuit whereby the collector-to-base voltage of the third transistor branch is compensated for temperature variations and power source variations, the current flow through said third transistor being used as a base input signal to the current source transistor.

3.  An amplifier as claimed in Claim 2, wherein the first, second and third transistors are all located proximate to the differential transistors.

4.  An amplifier as claimed in Claim 2 or 3, wherein the ratio of resistance of the second circuit branch to the first circuit branch is sufficiently high to cause a ratio of about 100:1 in the respective branch currents.

5.  An amplifier as claimed in Claim 2, 3 or 4, wherein each circuit branch includes an additional transistor in the collector circuit of the respective branch transistor.

6.  An amplifier as claimed in Claim 5, further including a fourth circuit branch comprising two transistors connected in series between a reference voltage and ground, the bases of the transistors being connected, respectively, to the bases of the transistors of the first circuit branch.